# EUROPEAN PATENT APPLICATION

(11) **EP 1 261 083 A1**
(43) Date of publication of application: **27.11.2002**
(21) Application number: 01304662.8
(22) Date of filing: 25.05.2001
(51) Int. Cl.: H01S 5/0683, H03F 1/56

(54) **Driver circuit apparatus, measuring circuit apparatus and amplifier circuit apparatus therefor**

(71) Applicant: Agilent Technologies, Inc. (a Delaware corporation), Palo Alto, CA 94303 (US)
(72) Inventor: Vaugham, Barry John, Ipswich, Suffolk IP3 8UT (GB)
(74) Representative: Coker, David Graeme

(57) **Abstract**

In known control loops to control a bias current of a laser device, the presence of a parasitic current drawn by an operational amplifier (114) of a monitoring circuit (100) introduces inaccuracies into measurements of mean power output of the laser device. The present invention provides the operational amplifier with an input stage (200) comprising MOSFETs (208, 210), thereby obviating the parasitic current.

## Description

The present invention relates to an amplifier circuit apparatus of the type used in a measuring circuit of a driver circuit for measuring mean output power of a laser device, for example a semiconductor laser device, such as a Fabri-Perot semiconductor laser.

A known laser driver circuit comprises a control loop arranged to control bias current to a laser device. A measured voltage corresponding to a measured mean power output of the laser device is compared with a predetermined reference voltage and the bias current is adjusted in response to any difference between the measured voltage and the predetermined reference voltage.

The mean power output of the laser device is measured by disposing a photodiode sufficiently close to a back facet of the laser device to receive light emitted from the back facet. A current generated, in response to the light received by the photodiode from the back facet, flows through a resistor to yield a voltage drop thereacross. The voltage drop across the resistor is applied to an inverting input of an operational amplifier arranged to generate an accumulating signal indicative of a deviation of the voltage drop from a predetermined voltage level (applied to a non-inverting input of the operational amplifier) corresponding to the predetermined output power.

Disadvantageously, the operational amplifier draws a parasitic current into the inverting input, some known operational amplifiers drawing up to twenty percent of the current generated by the photodiode subject to, for example, changes in temperature of the operational amplifier. Siphoning-off the current generated by photodiode lowers the voltage drop across the resistor and consequently the voltage drop applied at the inverting input of the operational amplifier. Hence, it can be seen that measurement of the mean power output of the laser device will be inaccurate.

A known solution to reduce the parasitic current comprises ensuring the current generated by the photodiode does not drop to a level sufficiently low for the parasitic current to be a significant proportion of the current generated by the photodiode. However, it is not always possible to ensure sufficient current is generated by the photodiode to ensure that the parasitic current is an insignificant proportion of the current generated by the photodiode.

According to a first aspect of the present invention, there is provided an amplifier circuit apparatus for a measuring circuit capable of measuring mean power output of a laser device, the apparatus comprising an input stage having a first input, and an output stage, characterised in that the input stage is adapted so as substantially not to draw an electric current through the first input.

Preferably, the input stage is adapted to comprise a first insulated gate field effect active device having a control input, the control input corresponding to the first input of the input stage.

It should be appreciated that reference to insulated gate field effect active devices is intended to include metal oxide field effect active devices, for example Metal Oxide Field Effect Transistors (MOSFETs).

Preferably, the input stage also comprises non-insulated gate active devices, for example, bipolar transistors.

Preferably, the output stage comprises non-insulated gate active devices, for example, bipolar transistors.

Preferably, the input stage comprises a differential pair topology, the differential pair topology comprising the first insulated gate active device and a second insulated gate active device. More preferably, the first insulated gate active device is a first Insulated Gate Field Effect Transistor (IGFET) and the second insulated gate active device is a second IGFET.

Preferably, the input stage comprises a second input. More preferably, the second input is a control input of the second insulated gate active device.

According to a second aspect of the present invention, there is provided a measuring circuit apparatus for measuring mean power output of a laser device, the apparatus comprising an amplifier circuit apparatus as set forth above in relation to the first aspect of the present invention.

Preferably, the apparatus further comprises a transducer arranged to translate an optical signal into a voltage signal and apply the voltage signal to the first input of the input stage.

According to a third aspect of the present invention, there is provided a driver circuit apparatus for a laser device, the driver circuit apparatus comprising the apparatus as set forth above in relation to the first or second aspects of the present invention.

According to a fourth aspect of the present invention, there is provided an optical communications network comprising the apparatus as set forth in relation to any one of the first, second or third aspects of the present invention.

It is thus possible to provide an amplifier circuit apparatus, a measuring circuit apparatus and a driver circuit apparatus that does not siphon the parasitic current off of the current permitted to flow by the photodiode. Advantageously, the absence of the parasitic current results in improved accuracy in measuring the mean power output of the laser device. Consequently, the mean power, extinction ratio and/or other characteristics of a signal generated by the laser, device can be controlled with greater accuracy.

At least one embodiment of the present invention will now be described, by way of example only, with reference to the accompanying drawings, in which:
**Figure 1** is a schematic diagram of a measuring circuit constituting an embodiment of the present invention, and
**Figure 2** is a schematic diagram of an input stage circuit of an operational amplifier for use with the circuit of Figure 1.

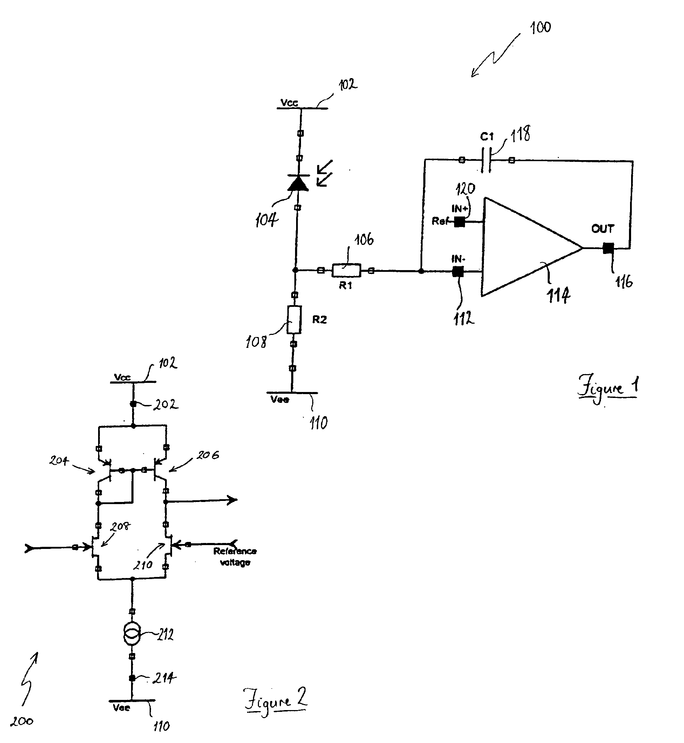

Referring to Figure 1, a monitoring circuit 100 comprises a first supply rail 102 at a first potential (V_{cc}) coupled to a cathode of a photodiode 104. An anode of the photodiode 104 is coupled to a first terminal of a first resistor 106 and a first terminal of a second resistor 108, a second terminal of the second resistor 108 being coupled to a second supply rail 110 at a second potential (Vₑₑ).

A second terminal of the first resistor 106 is coupled to an inverting input terminal 112 of an operational amplifier 114. An output terminal 116 of the operational amplifier 114 is coupled to a first terminal of a capacitor 118, a second terminal of the capacitor 118 being coupled to the inverting input terminal 112; The operational amplifier 114 also comprises a non-inverting input terminal 120 and, although not illustrated, the operational amplifier 114 is coupled to the first and second supply rails 102, 110.

The first resistor 106, the operational amplifier 114 and the capacitor 118 form an averaging configuration known in the art capable of generating an output signal indicative of a mean deviation of a first input signal from a second input signal.

The operational amplifier 114 comprises an input stage 200 (Figure 2) and an output stage (not shown). The output stage can be any compatible output stage known in the art depending upon the application for which the operational amplifier 114 is required. In this example, the output stage comprises bipolar active devices, such as bipolar transistors, due to a need for a low capacitance active device to drive a semiconductor laser device at a high data rate.

Similarly, depending upon the application for which the operational amplifier 114 is required, the operational amplifier 114 can comprise a number of intermediate stages (not shown) between the input stage 200 and the output stage.

Referring to Figure 2, a first supply terminal 202 is coupled to the first supply rail 102 and an emitter terminal of a first PNP transistor 204 and an emitter terminal of a second PNP transistor 206. A base terminal of the first PNP transistor 204 is coupled to a base terminal of the second PNP transistor 206 and a collector terminal of the first PNP transistor 204. The collector terminal of the first PNP transistor 204 is coupled to a drain terminal of a first MOSFET 208, a source terminal of the first MOSFET 208 being coupled to a first terminal of a current source 212. A second terminal of the current source 212 is coupled to a second supply terminal 214, the second supply terminal 214 being coupled to the second supply rail 110.

A collector terminal of the second PNP transistor 206 is coupled to a drain terminal of a second MOSFET 210, a source terminal of the second MOSFET 210 being coupled to the first terminal of the current source 212.

A gate terminal of the first MOSFET 208 is coupled to the inverting input terminal 112 and the gate terminal of the second MOSFET 210 is coupled to the non-inverting input terminal 120.

As a skilled person would appreciate, the first and second PNP transistors 204, 208, the first and second MOSFETs 208, 210 and the current source 212 are arranged to form what is known in the art as a "differential pair with current mirror load" configuration.

In operation, light emitted from a back-facet of the semiconductor laser device (not shown) is incident upon the photodiode 104, resulting in the photodiode 104 generating a first current. The first current is fed into the second resistor 108 resulting in a voltage being developed across the second resistor 108. The voltage developed is modulated by the photodiode 104 to form a varying voltage signal, the amplitude of the voltage signal proportional to amplitude of the light incident upon the photodiode 104. The voltage signal is averaged by the averaging configuration to form a mean power output and the mean power output is compared with a predetermined output power level, an output signal at the output terminal 116 of the operational amplifier 114 corresponding to a deviation of the voltage signal from the predetermined output power level. The output signal is then used by a control circuit (not shown) to adjust a bias current of the laser device.

The operational amplifier 114 of the integrator circuit configuration operates in a like manner to any other operational amplifier. In this respect, the input stage operates in a like manner to any differential pair configuration known in the art. However, the use of the first and second MOSFETs 208, 210 results in the inverting and non-inverting input terminals having infinite, or as near as practicably possible infinite, input impedance to DC signals. Therefore, no parasitic current flows through the non-inverting input terminal 120 and, more importantly, through the inverting input terminal 112.

Although, in the above example, the first and second MOSFETs 208, 210 are employed in the input stage 200, it should be appreciated that any type of active device having a control terminal that does not draw an electric current, for example any Insulated Gate Field Effect Transistor (IGFET), can be employed.

## Claims

1. An amplifier circuit apparatus for a measuring circuit (100) capable of measuring mean power output of a laser device, the apparatus comprising an input stage (200) having a first input, and an output stage, **characterised in that** the input stage (200) is adapted so as substantially not to draw an electric current through the first input.

2. An apparatus as claimed in claim 1, wherein the input stage (200) is adapted to comprise a first insulated gate field effect active device (208) having a control input, the control input corresponding to the first input of the input stage (200).

3. An. apparatus as claimed in claim 1 or claim 2, wherein the input stage (200) also comprises non-insulated gate active devices (204, 206).

4. An apparatus as claimed in claim 1, 2 or 3, wherein the output stage comprises non-insulated gate active devices.

5. An apparatus as claimed in any one of claims 2 to 4, wherein the input stage (200) comprises a differential pair topology, the differential pair topology comprising the first insulated gate active device (208) and a second insulated gate active device (210).

6. An apparatus as claimed in claim 5, wherein the first insulated gate active device (208) is a first Insulated Gate Field Effect Transistor (IGFET) and the second insulated gate active device (210) is a second IGFET.

7. A measuring circuit apparatus (100) for measuring mean power output of a laser device, the apparatus comprising an amplifier circuit apparatus as claimed in any one of the preceding claims.

8. An apparatus as claimed in claim 7, further comprising a transducer (104) arranged to translate an optical signal into a voltage signal and apply the voltage signal to the first input of the input stage (200).

9. A driver circuit apparatus for a laser device, the driver circuit apparatus comprising the apparatus as claimed in any of the preceding claims.

10. An optical communications network comprising the apparatus as claimed in any one of the preceding claims.
